(19) Europäisches Patentamt
European Patent Office
Office européen des brevets

(11) **EP 4 510 165 A1**

(12) **EUROPEAN PATENT APPLICATION**
published in accordance with Art. 153(4) EPC

(43) Date of publication:
**19.02.2025 Bulletin 2025/08**

(21) Application number: **23826256.2**

(22) Date of filing: **15.06.2023**

(51) International Patent Classification (IPC):
*H01H 71/04* (2006.01)     *G01R 31/327* (2006.01)

(52) Cooperative Patent Classification (CPC):
**G01R 31/327; H01H 71/04**

(86) International application number:
**PCT/CN2023/100340**

(87) International publication number:
**WO 2023/246607 (28.12.2023 Gazette 2023/52)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.06.2022  CN 202210696217**

(71) Applicant: **Zhejiang Chint Electrics Co., Ltd.**
**Yueqing, Zhejiang 325603 (CN)**

(72) Inventors:
• **ZHANG, Shiwei**
  **Wenzhou, Zhejiang 325603 (CN)**

• **LI, Shengyan**
  **Wenzhou, Zhejiang 325603 (CN)**
• **YAN, Dongdong**
  **Wenzhou, Zhejiang 325603 (CN)**
• **CHEN, Longyu**
  **Wenzhou, Zhejiang 325603 (CN)**
• **WEI, Jie**
  **Wenzhou, Zhejiang 325603 (CN)**
• **CAI, Mengmeng**
  **Wenzhou, Zhejiang 325603 (CN)**

(74) Representative: **Petraz, Gilberto Luigi et al**
**GLP S.r.l.**
**Viale Europa Unita, 171**
**33100 Udine (IT)**

(54) **COMPREHENSIVE-SENSING AIR CIRCUIT BREAKER**

(57)    The present invention relates to the field of low-voltage electrical appliances, in particular to a comprehensive perception universal circuit breaker. An intelligent controller of a control system includes an MCU circuit. A circuit breaker self-inspection module of the intelligent controller includes a current sampling circuit. The current sampling circuit includes a transformer disconnection detection circuit for detecting a connection state of an air-core transformer; an iron core transformer working current detection circuit for detecting an output current of an iron core transformer; a magnetic flux tripping unit disconnection detection circuit for detecting a connection state of a magnetic flux tripping unit of an execution unit; an auxiliary power supply voltage detection circuit for detecting an input state of an auxiliary power supply which supplies power to a short-circuit protection mechanism; an energy storage readiness detection circuit for detecting an energy storage state of the energy storage operating mechanism; and a tripping state detection circuit for detecting a tripping state of the universal circuit breaker. The circuit breaker self-inspection module of the comprehensive perception uni-versal circuit breaker can perform self-inspection on the working state of the universal circuit breaker, and ensure reliable and stable working of the universal circuit breaker.

FIG. 11

EP 4 510 165 A1

**Description**

**TECHNICAL FIELD**

The present invention relates to the field of low-voltage electrical appliances, in particular to a comprehensive perception universal circuit breaker.

**BACKGROUND**

The traditional universal circuit breaker has a core function of protecting a power distribution network, and is generally equipped with an intelligent controller with relatively simple functions, so just current and voltage parameters are collected generally. With the continuous improvement and completion of product performances, higher requirements are also put forward for its reliability, so it is necessary to monitor a working state of the product itself, but the existing universal circuit breaker cannot meet this demand.

**SUMMARY**

An object of the present invention is to overcome the defects of the prior art, and to provide a comprehensive perception universal circuit breaker, of which a circuit breaker self-inspection module can carry out self-inspection on a working state of the universal circuit breaker, thereby ensuring that the universal circuit breaker works reliably and stably.

In order to achieve the above object, the present invention adopts the following technical solutions:

A comprehensive perception universal circuit breaker, comprising a circuit breaker body and a control system, wherein the control system comprises an intelligent controller, and the intelligent controller comprises an MCU circuit and a circuit breaker self-inspection module connected to the MCU circuit; and
the circuit breaker self-inspection module comprises:

a current sampling circuit, which comprises a transformer disconnection detection circuit for detecting a connection state of an air-core transformer of the universal circuit breaker;
an iron core transformer working current detection circuit for detecting an output current of an iron core transformer of the universal circuit breaker;
a magnetic flux tripping unit disconnection detection circuit for detecting a connection state of a magnetic flux tripping unit of an execution unit of the universal circuit breaker;
an auxiliary power supply voltage detection circuit for detecting an input state of an auxiliary power supply which supplies power to a short-circuit protection mechanism of the universal circuit breaker;
an energy storage readiness detection circuit for detecting an energy storage state of the energy storage operating mechanism of the universal circuit breaker; and
a tripping state detection circuit for detecting a tripping state of the universal circuit breaker.

Preferably, the current sampling circuit comprises a current processing circuit; the current processing circuit comprises an integrating circuit and an amplifying circuit; and a signal of the air-core transformer is processed and transmitted to the MCU circuit.

Preferably, the iron core transformer working current detection circuit is connected with an AD sampling port of the MCU circuit, and converts an output current signal of the iron core transformer into a voltage signal and transmits the voltage signal to the MCU circuit through the AD sampling port.

Preferably, the magnetic flux tripping unit disconnection detection circuit comprises a diode D6, a diode D8, a resistor R1, a resistor R2 and a comparator U4A; a cathode of the diode D6 is connected with a cathode of the diode D8; an anode of the diode D8 is connected with one end of the resistor R1, and the other end of the resistor R1 is connected with one end of the resistor R2; the other end of the resistor R2 is connected with a positive input terminal of the comparator U4A; a node between the diode D6 and the diode D8, and a node between the diode D8 and the resistor R1 are connected with a magnetic flux coil, respectively.

Preferably, the auxiliary power supply voltage detection circuit is connected with the AD sampling port of the MCU circuit, and transmits to the MCU circuit after performing a resistance voltage division and a power supply filtering on the auxiliary power supply.

Preferably, the circuit breaker self-inspection module further comprises a busbar temperature collection circuit for detecting a busbar temperature inside the universal circuit breaker.

Preferably, the universal circuit breaker further comprising a position monitoring module for detecting a working position where the circuit breaker body is located.

Preferably, the intelligent controller further comprises a current and voltage measurement circuit; the current and voltage sampling circuit comprises a metering chip, and a current sampling portion and a voltage sampling portion connected to the metering chip, respectively; and the metering chip is connected with the MCU circuit.

Preferably, the universal circuit breaker further comprising an accessory detection module, wherein the accessory detection module comprises an undervoltage monitoring circuit, a shunt trip monitoring circuit, a closed monitoring circuit and a motor monitoring circuit which are used for detecting an undervoltage tripping unit, a shunt release, a closed electromagnet and an energy storage motor of the universal circuit breaker, respectively.

Preferably, the intelligent controller further comprises an environment monitoring module connected with the MCU circuit; and the environment monitoring module comprises a temperature and humidity sensing circuit, an atmospheric pressure measurement circuit and a dust detection circuit.

Preferably, the intelligent controller comprises an interface board, a power supply board, a control board, an MCR protection board, a wireless communication module and a liquid crystal display module.

Preferably, the intelligent controller further comprises a controller housing; the controller housing comprises a transparent long door that extends to a key-press portion and is provided with a lock structure.

Preferably, the intelligent controller calculates a contact wear rate of the universal circuit breaker by the following method:

$$\eta(n) = 1/[(\text{In}/\text{I}(n))^{\wedge}\alpha * \text{Le}]$$

$$\eta = [\eta(1) + \eta(2) + \cdots \eta(n)]$$

in which: $\eta(n)$ is a wear rate of single opening; a minimum value is the reciprocal of the mechanical life; $\eta$ is a total contact wear rate; In is a rated current; I(n) is an opening current; $\alpha$ is a coefficient, i.e., a constant; Le is the electric life of the product, i.e., a constant.

Preferably, the intelligent controller calculates a thermal aging rate of the universal circuit breaker by the following method:

$$R = 1 - (N - (I/0.8\text{In})^{\wedge}2 * (W/40)^{\wedge}2 * D)/N$$

in which: R is a thermal aging rate of the universal circuit breaker; N is the number of design depreciation days; I is an average current of daily operation; W is an operating ambient temperature of the universal circuit breaker; and D is a cumulative days of operation.

Preferably, the intelligent controller calculates the health degree of the universal circuit breaker by the following method:

$$H = \min [(1 - R * 100), (1 - \eta * 100)]$$

in which: H is the health degree of the universal circuit breaker; R is a thermal aging rate of the circuit breaker; and $\eta$ is a contact wear rate.

According to the comprehensive perception universal circuit breaker, a circuit breaker self-inspection module of an intelligent controller can detect a plurality of components or structures of the universal circuit breaker so as to determine whether these components or structures work normally, thereby ensuring that the universal circuit breaker operates in correct mode.

In addition, according to the comprehensive perception universal circuit breaker of the present invention, the intelligent controller also includes an environment monitoring module which is used for detecting an environment in which the universal circuit breaker is located, thereby ensuring that the universal circuit breaker works in a correct mode.

In addition, according to the comprehensive perception universal circuit breaker of the present invention, the intelligent controller can also calculate a contact wear rate, a thermal aging rate and a health degree, so that a user can grasp the mechanical and electrical life of the universal circuit breaker in real time, thereby ensuring the reliability and stability of a distribution network.

In addition, according to the comprehensive perception universal circuit breaker of the present invention, an accessory detection module may detect a working state of each accessory in real time, thereby ensuring the reliable and stable operation of each accessory.

## BRIEF DESCRIPTION OF THE DRAWINGS

FIG. 1 is a schematic structural diagram of a comprehensive perception universal circuit breaker of the present invention;

FIG. 2a is a schematic structural diagram of an intelligent controller in the present invention;

FIG. 2b is a schematic diagram of an exploded structure of the intelligent controller in the present invention;

FIG. 3 is a topological diagram of an MCU circuit in the present invention;

FIG. 4 is a topological diagram of a current processing circuit in the present invention;

FIG. 5 is a topological diagram of an iron core transformer working current detection circuit in the present invention;

FIG. 6 is a topological diagram of a magnetic flux tripping unit disconnection detection circuit in the present invention;

FIG. 7a is a topological diagram of an energy storage readiness detection circuit in the present invention;

FIG. 7b is a topological diagram of a tripping state detection circuit in the present invention;

FIG. 8a is a topological diagram of a current sampling portion in the present invention;

FIG. 8b is a topological diagram of a voltage sampling portion in the present invention;

FIG. 8c is a topological diagram of a metering chip in the present invention;

FIG. 9 is a topological diagram of a busbar temperature collection circuit in the present invention;

FIG. 10a is a topological diagram of a temperature and humidity sensing circuit in the present invention;

FIG. 10b is a topological diagram of an atmospheric pressure measurement circuit in the present invention;

FIG. 10c is a topological diagram of a dust detection circuit in the present invention;

FIG. 11 is a schematic diagram of functional modules of the comprehensive perception universal circuit breaker of the present invention; and

FIG. 12 is a topological diagram of an auxiliary power supply voltage detection circuit in the present invention.

## DETAILED DESCRIPTION OF THE INVENTION

The specific implementations of a comprehensive perception universal circuit breaker of the present invention will be further described below in conjunction with the embodiments given in the accompanying drawings of the specification. The comprehensive perception universal circuit breaker of the present invention is not limited to the description of the following embodiments.

The comprehensive perception universal circuit breaker of the present invention includes a circuit breaker body 1 and a control system. The control system includes an intelligent controller 2. The intelligent controller 2 includes an MCU circuit and a circuit breaker self-inspection module connected to the MCU circuit. The circuit breaker self-inspection module includes:

a current sampling circuit, which includes a transformer disconnection detection circuit for detecting a connection state of an air-core transformer of the universal circuit breaker;

an iron core transformer working current detection circuit for detecting an output current of an iron core transformer of the universal circuit breaker;

a magnetic flux tripping unit disconnection detection circuit for detecting a connection state of a magnetic flux tripping unit of an execution unit of the universal circuit breaker; and

an auxiliary power supply voltage detection circuit for detecting an input state of an auxiliary power supply which supplies power to a short-circuit protection mechanism of the universal circuit breaker.

In the comprehensive perception universal circuit breaker, a circuit breaker self-inspection module of an intelligent controller 2 can detect a plurality of components or structures of the universal circuit breaker so as to determine whether these components or structures work normally, thereby ensuring stable and reliable working of the universal circuit breaker.

The following is an embodiment of a comprehensive perception universal circuit breaker of the present invention.

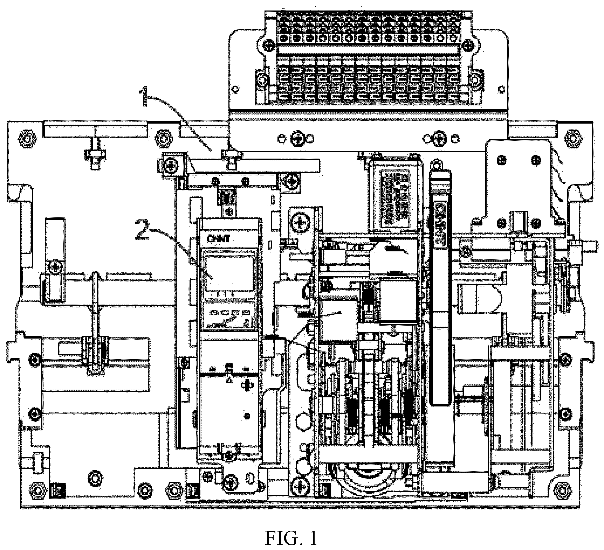

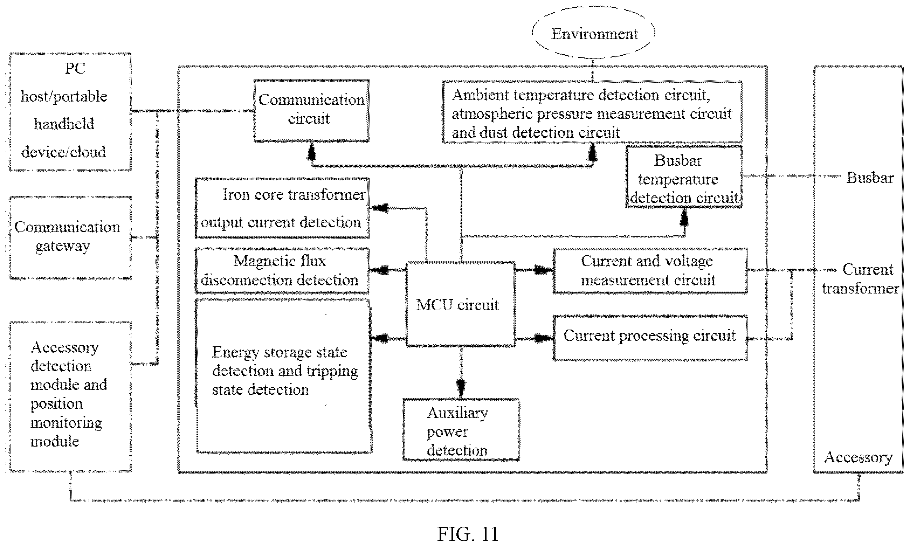

As shown in FIG. 1 and FIG. 11, the comprehensive perception universal circuit breaker of the present embodiment includes a circuit breaker body 1 and a control system. The control system includes an intelligent controller 2.

The circuit breaker body 1 includes a conductive system, an arc-extinguishing system and an operating mechanism. The operating mechanism is in driving connection with the conductive system to control the comprehensive perception universal circuit breaker to be closed or opened. The arc-extinguishing system cooperates with the conductive system to extinguish an arc generated when the conductive system is disconnected or closed.

As shown in FIG. 1, the intelligent controller 2 is fixedly arranged on the circuit breaker body 1.

As shown in FIG. 11, the intelligent controller 2 includes an MCU circuit and a circuit breaker self-inspection module connected to the MCU circuit. The circuit breaker self-inspection module includes a current sampling circuit, an iron core transformer working current detection circuit for monitoring an output current of the iron core transformer, a magnetic flux tripping unit disconnection detection circuit for detecting the connection state of the magnetic flux tripping unit of the execution unit and an auxiliary power supply voltage detection circuit for detecting the input state of the auxiliary power supply which supplies power to the short-circuit protection mechanism. The current sampling circuit includes a transformer disconnection detection circuit for detecting a connection state of an air-core transformer. Further, the circuit breaker self-inspection module further includes an energy storage readiness detection circuit for detecting an energy storage state of the energy storage operating mechanism, a tripping state detection circuit for detecting a tripping state of the universal circuit breaker, and a busbar temperature collection circuit for detecting a busbar temperature inside the universal circuit breaker.

As shown in FIG. 11, the intelligent controller 2 further includes a communication circuit. The communication circuit is in communication connection with a PC host and/or portable handheld device and/or cloud so as to carry out information display and/or alarming and/or carry out parameter setting to the intelligent controller 2. Further, the communication circuit is in communication connection with the PC host via RS485, with the portable handheld device via Bluetooth or WIFI, and with the cloud via the Internet.

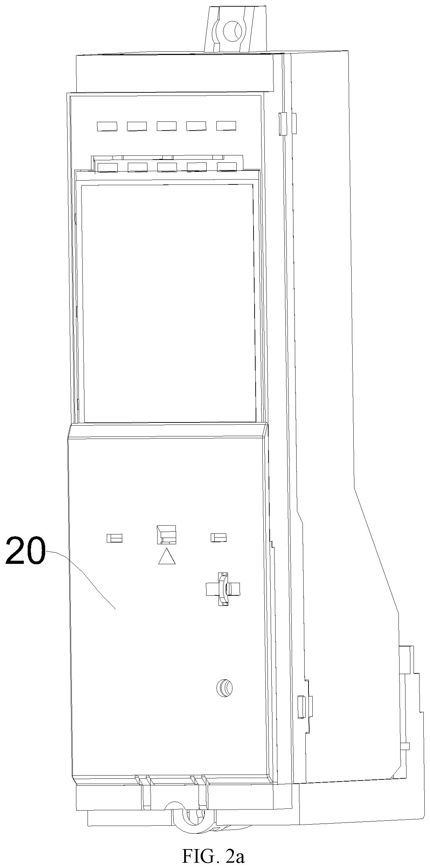

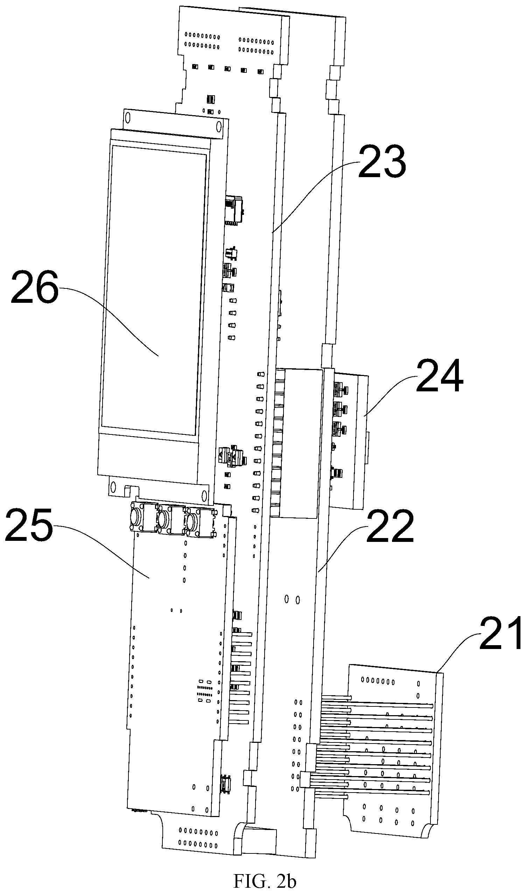

As shown in FIG. 2b, the intelligent controller 2 includes an interface board 21, a power supply board 22, a control board 23, an MCR protection board 24, a wireless communication module 25 and a liquid crystal display module 26. Further, as shown in FIG. 2a, the intelligent controller 2 further includes a controller housing. The above components are all mounted in the controller housing. The controller housing further includes a transparent long door 20. The transparent long door 20 extends to a key-press portion of the intelligent controller. The transparent long door is provided with a lock structure, thereby avoiding irrelevant personnel from operating the intelligent controller.

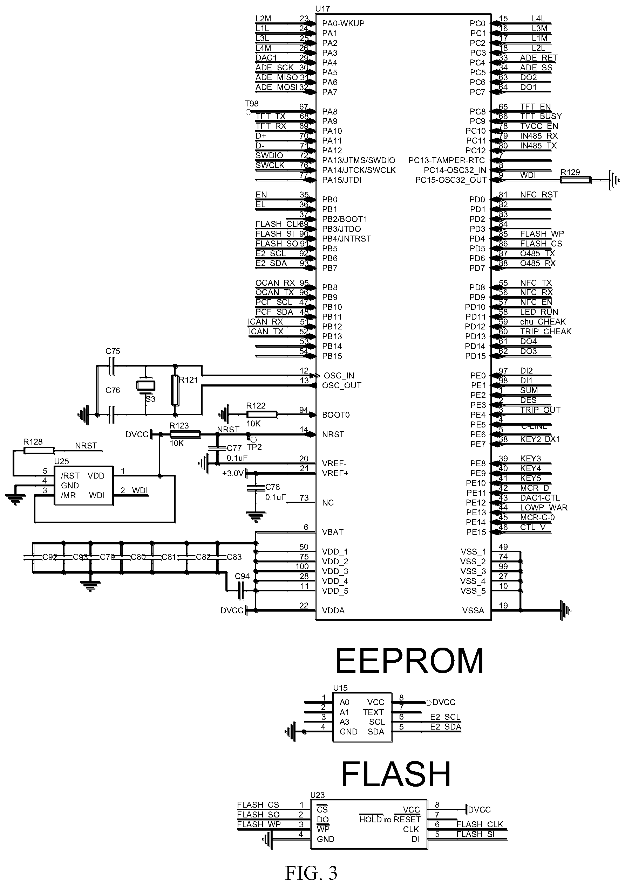

As shown in FIG. 3, an embodiment of the MCU circuit is shown.

The MCU circuit includes an EEPROM storage unit and a FLASH storage unit. The MCU circuit may determine whether the EEPROM storage unit and the FLASH storage unit are normally connected through data processing, so as to ensure the normal storage of information.

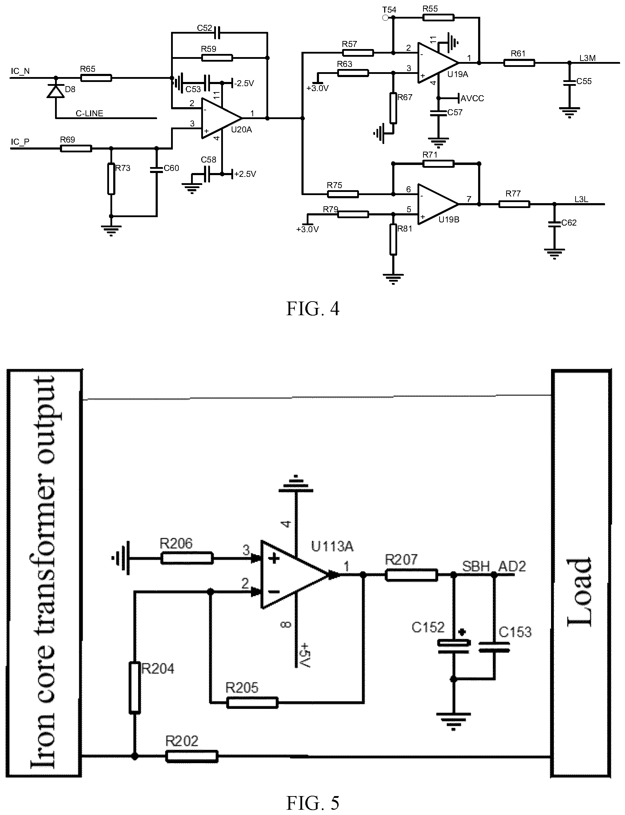

As shown in FIG. 4, the current sampling circuit includes a current processing circuit. The current processing circuit includes an integrating circuit and an amplifying circuit, by which a signal of the air-core transformer is processed and transmitted to the MCU circuit. Further, the integrating circuit filters the signal of the air-core transformer, and then amplifies the filtered signal through the amplifying circuit. The amplifying circuit includes two paths, wherein one path has a relatively large amplification factor for detecting a front-end small signal, and is connected to the MCU circuit for AD conversion after amplification; and the other path has a relatively small amplification factor for detecting a front-end large signal, and is also connected to the MCU circuit for AD conversion.

Respective phases of the current processing circuit are in one-to-one correspondence to respective phases of the universal circuit breaker. That is, each phase of the universal circuit breaker is connected to one current processing circuit respectively, and the respective current processing circuits have the same structure. For example, when the universal circuit breaker is a four-phase circuit breaker, various phases A, B, C and D are connected with four current processing circuits, respectively.

The following is an example of a current processing circuit connected to the C phase of the universal circuit breaker, hereinafter referred to as a C-phase current processing circuit:

as shown in FIG. 4, the C-phase current processing circuit includes an amplifier U19A, an amplifier U19B and an amplifier U20A. A positive input terminal (a third pin) of the amplifier U20A is grounded through a capacitor C60. A resistor R73 is connected in parallel with a capacitor C60. A positive input terminal of the amplifier U20A is also connected with an IC_P terminal through a resistor R69, and an inverting input terminal (a second pin) of the amplifier U20A is connected with an IC_N terminal through a resistor R65. The IC_P terminal and the IC_N terminal are connected with an output terminal of an air-core transformer of a C phase of the universal circuit breaker, respectively. An anode of a diode D8 is connected with a node between the resistor R65 and the IC_N terminal, and a cathode of the diode D8 is connected with a C_LINE terminal. The C_LINE terminal is connected with a fifth pin of the MCU. An inverting input terminal of the amplifier U20A is also connected with an output terminal (a first pin) of the amplifier U20A through a resistor R59 and a capacitor C52 which are connected in parallel. A negative-side power pin (an eleventh pin) of the amplifier U20A is grounded through a capacitor C53 and connected with a -2.5V power supply, and a positive-side power pin (a fourth pin) of the amplifier U20A is grounded through a capacitor C58 and connected with a +2.5V power supply. An output terminal of the amplifier U20A is connected with an inverting input terminal (a second pin) of the amplifier U19A through a resistor R57. A positive input terminal of the amplifier U19A is grounded through a resistor R67 and connected with a +3.0V power supply through a resistor R63. An inverting input terminal of the amplifier U19A is connected with an output terminal (a first pin) of the amplifier U19A through a resistor R55. A node between the amplifier U19A and the resistor R55 is a T54 node. The T54 node may be used as a testing node. An output terminal of the amplifier U19A is grounded through a resistor R61 and a capacitor C55 which are sequentially connected in series. A negative-side power pin (an eleventh pin) of the amplifier U19A is grounded, and a positive-side power pin of the amplifier U19A is grounded through a capacitor C57 and connected to an AVCC terminal (the AVCC terminal is preferably a positive terminal of a 3.3V power supply which is connected to a twenty-sixth pin of a metering chip of a current and voltage sampling circuit). A node between the resistor R61 and the capacitor C55 is an L3M node. The L3M node is connected to a sixteenth pin of the MCU. An output terminal of the amplifier U20A is connected with an inverting input terminal (a sixth pin) of the amplifier U19B through a resistor R75. An inverting input terminal of the amplifier U19B is connected with an output terminal (a seventh pin) of the amplifier U19B through a resistor R71. A positive input terminal (a fifth pin) of the amplifier U19B is grounded through a resistor R81 and connected with a +3.0V power supply through a resistor R71. An output terminal of the amplifier U19B is grounded through a resistor R77 and a capacitor C62 which are connected in series. A node between the resistor R77 and the capacitor C62 is an L3L node. The L3L node is connected with a twenty-fifth pin of the MCU.

The current sampling circuit further includes a transformer disconnection detection circuit for detecting the connection state of the air-core transformer of the universal circuit breaker. Further, the transformer disconnection detection circuit includes four diodes for detecting whether the air-core transformer is normally connected, so as to identify a transformer disconnection fault in advance. Further, the four diodes include a diode D8 of a C-phase current processing circuit and corresponding diodes of the remaining three-phase (A, B, D) current processing circuits. For example, if the C-phase air-core transformer is not disconnected, an anode of the diode D8 is connected to a fifth pin of the MCU, the MCU pin is in a high level, and the level of the amplifying circuit may be raised to about 3V (1.5V in a normal state); and if the C-phase air-core transformer is disconnected, the MCU pin is in a low level.

As shown in FIG. 5, the iron core transformer working current detection circuit is connected with an AD sampling port of the MCU circuit.

As shown in FIG. 5, the iron core transformer working current detection circuit transforms an output current signal of the iron core transformer into a voltage signal and transmits the voltage signal to the MCU circuit so as to monitor whether the iron core transformer outputs a working current reliably and stably (e.g., whether voltage and current values remain stable) in real time. Further, after an output current of the iron core transformer flows through a resistor R202, a potential difference is generated at both ends of the resistor R202, amplified by an operational amplifier and then transmitted to the MCU circuit so as to calculate the output current of the iron core transformer.

Specifically, as shown in FIG. 5, the iron core transformer working current detection circuit includes a resistor R202, a resistor R204, a resistor R205, a resistor R206, a resistor R207, an amplifier U113A, a polar capacitor C152 and a capacitor C153. The resistor R202 is connected in series between one output terminal of the iron core transformer and a load. One end of the resistance R204 is connected with a node between the iron core transformer and the resistor R202, and the other end of the resistor R204 is connected with an inverting input terminal of the amplifier U113A. The resistor R205 is connected in series between an inverting input terminal (a second pin) and an output terminal (a first pin) of the amplifier U113A. A positive input terminal (a third pin) of the amplifier U113A is grounded through the resistor R206. An output terminal of the amplifier U113A is connected with the MCU circuit through the resistor R207. A positive-side power pin (a fourth pin) of the amplifier U113A is grounded. A negative-side power pin (an eighth pin) of the amplifier U113A is connected to a +5V power supply. An anode of the polar capacitor C_152 is connected with a node between the resistor R207 and the MCU circuit. A cathode of the polar capacitor C152 is grounded. The capacitor C153 is connected in parallel with the polar capacitor C152.

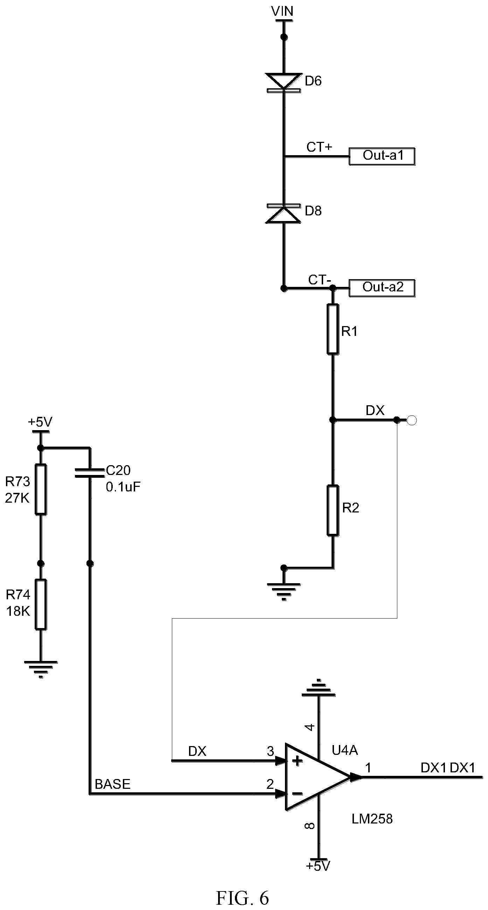

As shown in FIG. 6, the magnetic flux tripping unit disconnection detection circuit is used for detecting the connection state (a normal connection state or a disconnection state) of the magnetic flux tripping unit of the execution unit of the universal circuit breaker, and includes a diode D6, a diode D8, a resistor R1, a resistor R2 and a comparator U4A. A cathode of the diode D6 is connected with a cathode of the diode D8. An anode of the diode D8 is connected with one end of the resistor R1, and the other end of the resistor R1 is connected with one end of the resistor R2. The other end of the resistor R2 is connected with a positive input terminal of the comparator U4A. A node between the diode D6 and the diode D8 and a node between the diode D8 and the resistor R1 are connected with a magnetic flux coil, respectively.

Specifically, as shown in FIG. 6, the magnetic flux tripping unit disconnection detection circuit includes a diode D6, a diode D8, a resistor R1, a resistor R2 and an amplifier U4A. A cathode of the diode D6 is connected with a cathode of the diode D8. An anode of the diode D6 is connected with a VIN terminal. The VIN terminal is connected with an input power supply of the intelligent controller. An anode of the diode D8 is grounded through the resistor R1 and the resistor R2 which are sequentially connected in series. A node between the diode D6 and the diode D8 and a node between the diode D8 and the resistor R1 are connected with a magnetic flux tripping unit coil, respectively. A node between the resistor R1 and the resistor R2 is a DX node. The DX node is connected with a positive input terminal (a third pin) of the comparator U4A. An inverting input terminal (a second pin) of the comparator U4A is grounded through a capacitor C20, a resistor R73 and a resistor R74 which are sequentially connected in series. A node between the capacitor C20 and the resistor R72 is connected with a +5V power supply. An output terminal (a first pin) of the comparator U4A is connected with a DX1DX1 terminal. The DX1DX1 terminal is connected with a thirty-eighth pin of the MCU. A positive-side power pin (a fourth pin) of the comparator U4A is grounded. A negative-side power pin (an eighth pin) of the comparator U4A is connected to the +5V power supply.

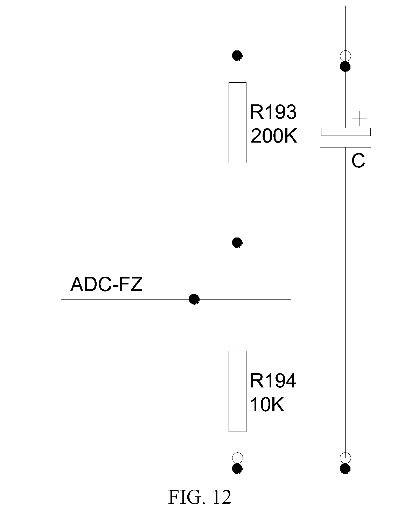

As shown in FIG. 12, the auxiliary power supply voltage detection circuit is connected with an AD sampling port of the MCU circuit, and transmits to the MCU circuit after performing a resistance division and a power filtering on the input terminal of an auxiliary power supply, so as to monitor an input state (e.g., the presence or absence of the auxiliary power supply, whether the voltage and current are stable, etc.) of the auxiliary power supply in real time, detect a power supply condition of the auxiliary power supply, and give priority to ensuring that a short-circuit protection function of the universal circuit breaker is performed.

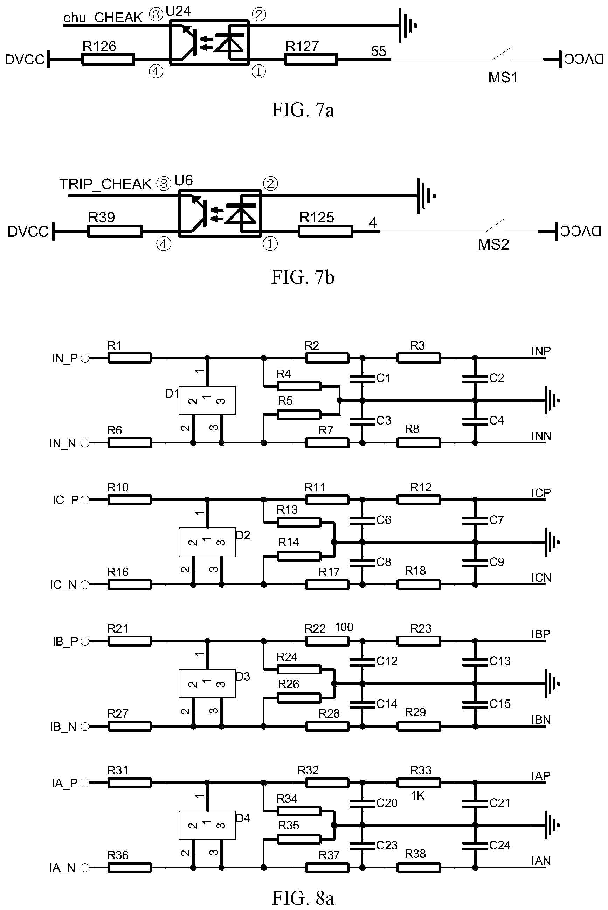

As shown in FIG. 7a, the energy storage readiness detection circuit is used for detecting whether an energy storage operating mechanism of the universal circuit breaker completes energy storage in real time, and includes an optocoupler U24 and an energy storage micro switch MS1. The energy storage micro switch MS1 cooperates with the energy storage operating mechanism. The energy storage operating mechanism completes energy storage and then triggers the energy storage micro switch MS1 to change a power-on state. A first pin of the optocoupler U24 is connected with a power supply DVCC through a resistor R127 and the energy storage micro switch MS1 which are sequentially connected in series, a second pin of the optocoupler U24 is grounded, a third pin of the optocoupler U24 is connected with a chu CHEAK terminal connected with a fifty-ninth of the MCU, and a fourth pin of the optocoupler U24 is connected with the power supply DVCC through a resistor R126.

As shown in FIG. 7b, the tripping state detection circuit is used for detecting a tripping state of the universal circuit breaker, that is, detecting whether the universal circuit breaker is tripped, including an optocoupler U6 and a tripping micro switch MS2. When the universal circuit breaker trips, the tripping micro switch MS2 is triggered to change a power-on state. A first pin of the optocoupler U6 is connected with the power supply DVCC through a resistor R125 and the tripping micro switch MS2 which are sequentially connected in series, a second pin of the optocoupler U6 is grounded, a third pin of the optocoupler U6 is connected with a TRIP_CHEAK terminal connected with a sixtieth pin of the MCU, and a fourth pin of the optocoupler U6 is connected with the power supply DVCC through a resistor R39.

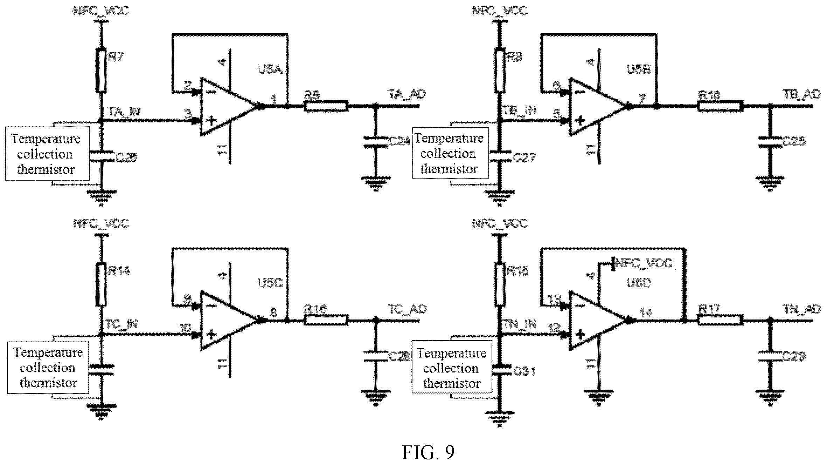

As shown in FIG. 9, the busbar temperature collection circuit detects a busbar temperature inside the universal circuit breaker in real time through a temperature collection thermistor installed on a busbar. Further, the universal circuit breaker in the present embodiment is a multi-phase (e.g., three-phase or four-phase) circuit breaker. Each phase of busbar of the universal circuit breaker is matched with the corresponding busbar temperature collection circuit. A description is made by taking the busbar temperature collection circuit corresponding to the following A-phase as an example: the busbar temperature collection circuit corresponding to an A-phase busbar of the universal circuit breaker includes an amplifier U5A. A positive input terminal (a third pin) of the amplifier U5A is grounded through a capacitor C26 and connected with an NFC_VCC power supply through a resistor R7. The capacitor C26 is connected in parallel with the temperature collection thermistor. An inverting input terminal (a second pin) of the amplifier U5A is connected with an output terminal (a first pin) of the amplifier U5A. An output terminal of the amplifier U5A is grounded through a resistor R9 and a capacitor C24 which are sequentially connected in series. A node between the resistor R9 and the capacitor C24 is connected with a TA_AD terminal. The TA_AD terminal may be directly connected to the MCU shown in FIG. 3 for temperature calculation or to a second MCU with a Bluetooth function. The second MCU calculates the temperature and then transmits temperature data to the MCU shown in FIG. 3 via serial communication. In the comprehensive perception universal circuit breaker, each phase is matched with the corresponding temperature collection thermistor and busbar temperature collection circuit.

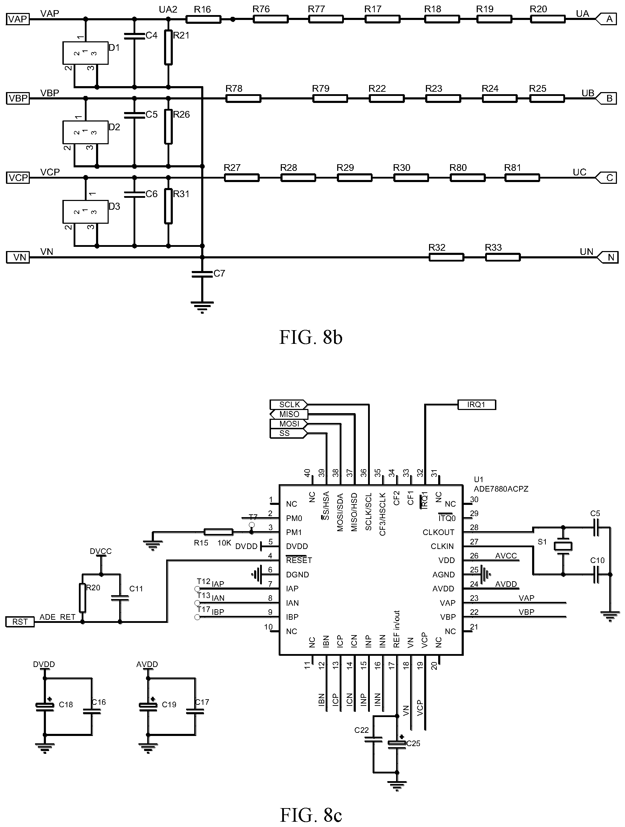

As shown in FIG. 8 and FIG. 11, the intelligent controller 2 further includes a current and voltage measurement circuit. The current and voltage sampling circuit includes a metering chip circuit, and a current sampling portion and a voltage sampling portion that are connected with the metering chip circuit, respectively. The metering chip circuit is connected with the MCU circuit. Further, the current and voltage sampling circuit is connected with the MCU circuit via serial communication. The metering chip circuit calculates data collected by the current sampling portion and the voltage sampling portion and transmits the data to the MCU circuit.

As shown in FIG. 8a, an embodiment of the current sampling portion is shown: the current sampling portion includes a plurality of (preferably, 4) current sampling branches, which are respectively used for collecting current signals of respective phases of the universal circuit breaker. A description is made by taking the current sampling branch of the current signal of the A phase of the universal circuit breaker as an example. This current sampling branch includes a triode D1. A first pin of the triode D1 is connected with the current transformer respectively through a resistor R1, second and third pins of the triode D1 and the resistor R6. A first pin of the triode D1 is also connected with an INP terminal through the resistor R2 and the resistor R3 which are sequentially connected in series, and the second and third pins of the triode D1 are also connected with an INN terminal through a resistor R7 and a resistor R8 which are sequentially connected in series. A first pin of the triode D1 is connected with the second and third pins of the triode D1 through a resistor R4 and a resistor R5 which are sequentially connected in series. A capacitor C1 and a capacitor C3 are sequentially connected in series between a node between the resistor R2 and the resistor R3 and a node between the resistor R7 and the resistor R8. A capacitor C2 and a capacitor C4 are sequentially connected in series between a node between the resistor R3 and the INP terminal and a node between the resistor R8 and the INN terminal. A node between the resistor R4 and the resistor R5, a node between the capacitor C1 and the capacitor C3 and a node between the capacitor C2 and the capacitor C4 are connected and grounded.

As shown in FIG. 8b, an embodiment of the voltage sampling portion is shown: the voltage sampling portion includes a plurality of (preferably, 4) voltage sampling branches, which is respectively used for collecting voltage signals of the respective phases of the universal circuit breaker. A description is made by taking the voltage sampling branch of the voltage signal of the A phase of the universal circuit breaker as an example. This voltage sampling branch includes a triode D1. A first pin of the triode D1 is connected with a VAP terminal and connected with the A phase of the universal circuit breaker through a resistor R16, a resistor R76, a resistor R77, a resistor R17, a resistor R18, a resistor R19 and a resistor R20 which are sequentially connected in series. The VAP terminal is connected with a twenty-third pin of the metering chip. The second and third pins of the triode D1 are grounded through a capacitor C7 and connected with a first pin of the triode D1 through C4 and a resistor R21 which are connected in parallel.

In the metering chip circuit, a metering chip is preferably a high-precision, three-phase electric energy metering IC, which adopts a serial interface and in which a plurality of two-stage $\Sigma$ - $\Delta$ -type analog-to-digital converters (ADCs), a digital integrator, a reference voltage source circuit and all necessary signal processing circuits are built, which can implement total (fundamental and harmonic) active/apparent power measurement and effective value calculation, as well as fundamental active/reactive power measurement.

As shown in FIG. 8c, an embodiment of the metering chip circuit is shown: the model of the metering chip is ADE7880, and seventh to ninth pins and twelfth to sixteenth pins are connected with four current sampling branches of the current sampling portion respectively, and eighteenth, nineteenth, twenty-second and twenty-third pins are connected with the four voltage sampling branches of the voltage sampling portion respectively.

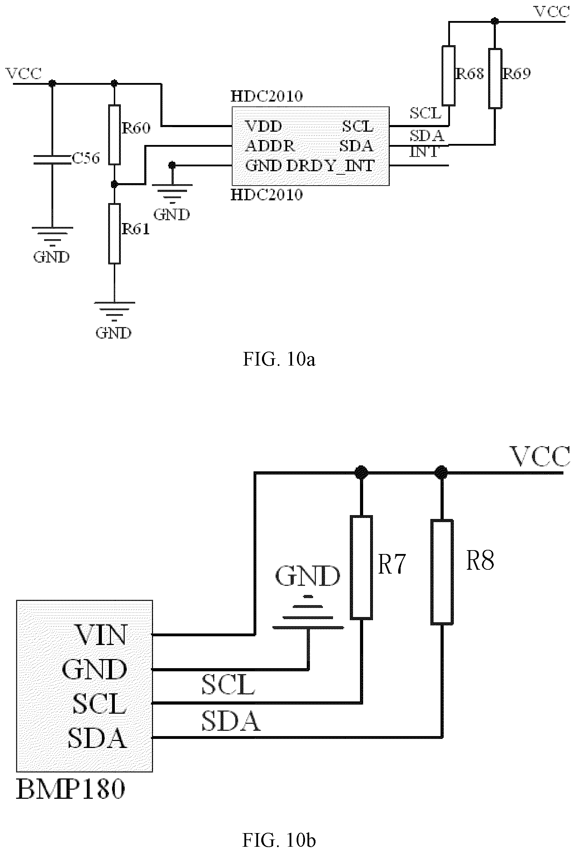

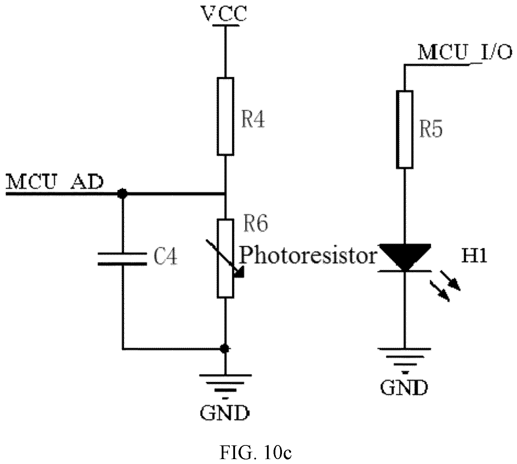

As shown in FIGS. 10-11, the intelligent controller 2 further includes an environment monitoring module connected with the MCU circuit. The environment monitoring module includes a temperature and humidity sensing circuit, an atmospheric pressure measurement circuit and a dust detection circuit. The temperature and humidity sensing circuit is centered on a high-precision temperature measuring chip having a model of HDC2010 and connected to the MCU circuit via a serial port. The atmospheric pressure measurement circuit is centered on a chip having a model of BMP 180 and connected to the MCU circuit via a serial port. The dust measurement circuit detects the illuminance of a light source through a photoresistor to determine a dust state in the environment.

As shown in FIG. 10a, an embodiment of the temperature and humidity sensing circuit is shown: the temperature and humidity sensing circuit includes a chip HDC2010. A VDD pin of the chip HDC2010 is connected to the power supply to provide a voltage of 1.62-3.6V. The VDD pin is also connected to GND through a capacitor C56. An ADDR pin defines an address. A resistor R60 is connected in parallel between the VDD pin and the ADDR pin of the HDC2010 temperature and humidity digital sensor. The ADDR pin is also connected to GND through a resistor R61. An SDA pin and an SCL pin are connected to a port of the MCU circuit through a pull-up resistor R68 and a pull-up resistor R69, respectively. A DRDY_INT pin is connected to the corresponding port of the MCU circuit. A GND pin is connected to GND. Further, the temperature and humidity detection circuit is connected to the MCU circuit of the intelligent controller 2. The intelligent controller 2 is preset with an ambient temperature threshold. For example, the ambient temperature threshold is 40°C, that is, an onboard temperature is 40°C. Taking a circuit breaker having a model of NA1-2000X-2000 as an example, a rated current In of the circuit breaker has a value of 2000A. When the ambient temperature is lower than 40°C, a protection value Ir of a long-delay current among protection parameters is 2000A, the MCU circuit obtains an ambient temperature parameter through a sampling signal of the temperature and humidity detection circuit, and compares the ambient temperature parameter with the ambient temperature threshold to determine whether the ambient temperature is abnormal, so as to prompt the user to manually adjust the long-delay current protection value Ir through an alarm via an HMI display module and a communication module. Further, within a certain period of time, such as 5-60 min, the long-delay current protection value Ir is not manually adjusted, and then the intelligent controller 2 adjusts the long-delay current protection value Ir according to a capacity reduction coefficient corresponding to the current ambient temperature. For example, when the ambient temperature changes to 55°C, the long-delay current protection value Ir is 2000×0.9=1800A according to the capacity reduction coefficient corresponding to the ambient temperature.

As shown in FIG. 10b, an embodiment of the atmospheric pressure measurement circuit is shown: the atmospheric pressure measurement circuit includes a chip BMP180M, wherein a communication mode adopts an I$^2$C communication protocol. An SDA pin and an SCL pin of the sensor are connected to the corresponding port of the intelligent controller 2 through a pull-up resistor R7 and a pull-up resistor R8, respectively. Further, the atmospheric pressure measurement circuit is connected to the MCU circuit of the intelligent controller 2. An altitude threshold is preset in the intelligent controller 2. For example, the altitude threshold is 2000 meters. Taking a circuit breaker having a model of NA1-2000X-2000 as an example, a rated current In of the circuit breaker is 2000A. When the altitude is lower than 2000 meters, the long-delay current protection value Ir among the protection parameters is 1000A, and the MCU circuit obtains an altitude parameter based on a sampling signal of the atmospheric pressure measurement circuit, compares the altitude parameter with an altitude threshold to determine whether an operating altitude of the circuit breaker is abnormal, so as to make an alarm through the HMI display module and the communication module and prompt that the circuit breaker is in a non-safe working state. Further, within a certain period of time, such as 5-60 min, the long-delay current protection value Ir is not manually adjusted, and then the intelligent controller 2 adjusts the long-delay current protection value Ir according to a capacity reduction coefficient corresponding to the current ambient temperature. For example, when the altitude changes to 3500 meters, the long-delay current protection value Ir is adjusted to 2000×0.83=1660A.

As shown in FIG. 10c, an embodiment of the dust detection circuit is shown: the dust detection circuit includes an LED light source H1, a photoresistor R6 and a heating resistor R4, wherein the LED light source H1 and the photoresistor R6 are used for collecting particle signals scattered in the air, and a sampling airflow is pushed by the heating resistor R4. During the sampling process, as dust particles in the air increase, the LED light source H1 is blocked, a resistance value of the photoresistor R6 decreases, and an AD sampling signal fed back to the intelligent controller 2 also decreases, such that the intelligent controller 2 can obtain the corresponding dust concentration level according to the built-in parameters, and remind the user to ventilate and exhaust. Further, both ends of the photoresistor R6 are connected in parallel with a capacitor C4, wherein one end of the photoresistor R6 is connected to the intelligent controller 2 to feed back a sampling signal, and the other end of the photoresistor R6 is connected to GND. One end of the LED light source H1 is connected to the intelligent controller 2 through a resistor R5. The LED light source H1 is controlled by the intelligent controller 2 to emit light.

As shown in FIG. 11, the universal circuit breaker of the present embodiment further includes a position monitoring module for detecting a working position where the circuit breaker body 1 is located. The circuit breaker body 1 has three working positions, which are a connection position, a test position and a separation position which are arranged in sequence. Further, the position monitoring module is connected with the intelligent controller 2 via RS485.

The position monitoring module can be realized through the prior art, for example, the technical solution of the Chinese patent CN211579947U, which will not be described herein.

As shown in FIG. 11, the universal circuit breaker further includes an accessory detection module. The accessory detection module includes an undervoltage monitoring circuit, a shunt trip monitoring circuit, a closed monitoring circuit and a motor monitoring circuit which are used for detecting an undervoltage tripping unit, a shunt release, a closed electromagnet and an energy storage motor of the universal circuit breaker, respectively. Further, the accessory detection module is connected with the intelligent controller via RS485.

The accessory detection module can be realized through the prior art, for example, the technical solution of the Chinese patent CN201922215425.5, which will not be described herein.

The intelligent controller 2 calculates a contact wear rate of the universal circuit breaker by the following method:

$$\eta(n) = 1/[(In/I(n))^{\wedge}\alpha * Le]$$

$$\eta = [\eta(1) + \eta(2) + \cdots \eta(n)]$$

in which: $\eta(n)$ is a wear rate of single opening, a minimum value is the reciprocal of the mechanical life; $\eta$ is a total contact wear rate; In is a rated current; I(n) is an opening current; $\alpha$ is a coefficient, i.e., a constant; Le is the electric life of the product, i.e., a constant.

The intelligent controller 2 calculates a thermal aging rate of the universal circuit breaker by the following method:

$$R = 1 - (N - (I/0.8In)^{\wedge}2 * (W/40)^{\wedge}2 * D)/N$$

in which: R is a thermal aging rate of the universal circuit breaker; N is the number of design depreciation days; I is an average current of daily operation; W is an operating ambient temperature of the universal circuit breaker; and D is a cumulative days of operation.

The intelligent controller 2 calculates the health degree of the universal circuit breaker by the following method:

$$H = \min [(1 - R * 100), (1 - \eta * 100)]$$

in which: H is the health degree of the universal circuit breaker; R is a thermal aging rate of the circuit breaker; and $\eta$ is a total contact wear rate.

The following is an example of the calculation of the contact wear rate:

Assuming that the universal circuit breaker has a rated current of 1000A and an opening current of 2000A, a coefficient a of 2, and the electrical life Le is of 10000;
the contact wear rate after one opening is:

$$\eta(1) = 1/ \ (((1000/2000) \ 2) \ \times 10000) \ = 0.04\%;$$

the contact wear rate after one more re-opening under the same parameters is $\eta(2) = 0.04\%$; and
a total contact wear rate after two opening is: $\eta = \eta(1) + \eta(2) = 0.08\%$.

An example of the calculation of the thermal aging rate and health degree is as follows:
assuming that the number N of design depreciation days is 5000 days, the average daily current I is 1000A, the rated current is 1000A, the ambient operating temperature is 40°C, and the cumulative days of operations is 1000.

$$R = 1 - (5000 - (1000/1600)\char`\^2 * (40/40)\char`\^2 * 1000)/5000 = 7.81\%$$

$$H = 1 - 0.0781 = 92.19\%.$$

It should be explained that, in the description of the present invention, the terms such as "up", "down", "left", "right", "inner" and "outer" indicating the directional or positional relations on the basis of the directional or positional relations shown in the drawings are only used for conveniently describing the present invention and simplifying the description, not indicate or imply that the referred devices or elements must have a specific orientation and be configured and operated in a specific direction; therefore, they cannot be construed as a limitation on the present invention.

We have made further detailed description of the present invention mentioned above in combination with specific preferred embodiments, but it is not deemed that the specific embodiments of the present invention is only limited to these descriptions. A person skilled in the art can also, without departing from the concept of the present invention, make several simple deductions or substitutions, which all be deemed to fall within the protection scope of the present invention.

**Claims**

1. A comprehensive perception universal circuit breaker, comprising a circuit breaker body (1) and a control system, wherein the control system comprises an intelligent controller (2), and the intelligent controller (2) comprises an MCU circuit and a circuit breaker self-inspection module connected to the MCU circuit; and
   the circuit breaker self-inspection module comprises:

   a current sampling circuit, which comprises a transformer disconnection detection circuit for detecting a connection state of an air-core transformer of the universal circuit breaker;
   an iron core transformer working current detection circuit for detecting an output current of an iron core transformer of the universal circuit breaker;
   a magnetic flux tripping unit disconnection detection circuit for detecting a connection state of a magnetic flux tripping unit of an execution unit of the universal circuit breaker;
   an auxiliary power supply voltage detection circuit for detecting an input state of an auxiliary power supply which supplies power to a short-circuit protection mechanism of the universal circuit breaker;
   an energy storage readiness detection circuit for detecting an energy storage state of the energy storage operating mechanism of the universal circuit breaker; and
   a tripping state detection circuit for detecting a tripping state of the universal circuit breaker.

2. The comprehensive perception universal circuit breaker according to claim 1, wherein the current sampling circuit comprises a current processing circuit; the current processing circuit comprises an integrating circuit and an amplifying circuit, by which a signal of the air-core transformer is processed and transmitted to the MCU circuit.

3. The comprehensive perception universal circuit breaker according to claim 1, wherein the iron core transformer working current detection circuit is connected with an AD sampling port of the MCU circuit, and converts an output current signal of the iron core transformer into a voltage signal, and transmits the voltage signal to the MCU circuit through the AD sampling port.

4. The comprehensive perception universal circuit breaker according to claim 1, wherein the magnetic flux tripping unit disconnection detection circuit comprises a diode D6, a diode D8, a resistor R1, a resistor R2 and a comparator U4A; a cathode of the diode D6 is connected with a cathode of the diode D8; an anode of the diode D8 is connected with one end of the resistor R1, and another end of the resistor R1 is connected with one end of the resistor R2; another end of the resistor R2 is connected with a positive input terminal of the comparator U4A; a node between the diode D6 and the diode D8, and a node between the diode D8 and the resistor R1 are connected with a magnetic flux coil, respectively.

5. The comprehensive perception universal circuit breaker according to claim 1, wherein the auxiliary power supply voltage detection circuit is connected with an AD sampling port of the MCU circuit, and transmits to the MCU circuit after performing a resistance voltage division and a power supply filtering on the auxiliary power supply.

6. The comprehensive perception universal circuit breaker according to claim 1, wherein the circuit breaker self-inspection module further comprises a busbar temperature collection circuit for detecting a busbar temperature inside the universal circuit breaker.

7. The comprehensive perception universal circuit breaker according to claim 1, the comprehensive perception universal circuit breaker further comprises a position monitoring module for detecting a working position where the circuit breaker body (1) is located.

8. The comprehensive perception universal circuit breaker according to claim 1, wherein the intelligent controller (2) further comprises a current and voltage sampling circuit; the current and voltage sampling circuit comprises a metering chip, and a current sampling portion and a voltage sampling portion connected to the metering chip, respectively; and the metering chip is connected with the MCU circuit.

9. The comprehensive perception universal circuit breaker according to claim 1, the comprehensive perception universal circuit breaker further comprises an accessory detection module, wherein the accessory detection module comprises an undervoltage monitoring circuit, a shunt trip monitoring circuit, a closed monitoring circuit and a motor monitoring circuit which are used for detecting an undervoltage tripping unit, a shunt release, a closed electromagnet and an energy storage motor of the universal circuit breaker, respectively.

10. The comprehensive perception universal circuit breaker according to claim 1, wherein the intelligent controller (2) further comprises an environment monitoring module connected with the MCU circuit; and the environment monitoring module comprises a temperature and humidity sensing circuit, an atmospheric pressure measurement circuit and a dust detection circuit.

11. The comprehensive perception universal circuit breaker according to claim 1, wherein the intelligent controller (2) comprises an interface board (21), a power supply board (22), a control board (23), an MCR protection board (24), a wireless communication module (25) and a liquid crystal display module (26).

12. The comprehensive perception universal circuit breaker according to claim 11, wherein the intelligent controller (2) further comprises a controller housing; the controller housing comprises a transparent long door that extends to a key-press portion and is provided with a lock structure.

13. The comprehensive perception universal circuit breaker according to claim 1, wherein:

the intelligent controller (2) calculates a contact wear rate of the universal circuit breaker by the following method:

$$\eta(n) = 1/[(In/I(n))^{\wedge}\alpha * Le]$$

$$\eta = [\eta(1) + \eta(2) + \cdots \eta(n)]$$

in which: $\eta(n)$ is a wear rate of single opening; a minimum value is the reciprocal of the mechanical life; $\eta$ is a total contact wear rate; In is a rated current; I(n) is an opening current; $\alpha$ is a coefficient, i.e., a constant; Le is the electric life of the product, i.e., a constant.

14. The comprehensive perception universal circuit breaker according to claim 1, wherein:

the intelligent controller (2) calculates a thermal aging rate of the universal circuit breaker by the following method:

$$R = 1 - (N - (I/0.8In)^{\wedge}2 * (W/40)^{\wedge}2 * D)/N$$

in which: R is a thermal aging rate of the universal circuit breaker; N is the number of design depreciation days; I is an average current of daily operation; W is an operating ambient temperature of the universal circuit breaker; and D is a cumulative days of operation.

15. The comprehensive perception universal circuit breaker according to claim 1 or 13 or 14, wherein:

the intelligent controller (2) calculates the health degree of the universal circuit breaker by the following method:

$$H = \min\left[(1 - R * 100), (1 - \eta * 100)\right]$$

in which: H is the health degree of the universal circuit breaker; R is a thermal aging rate of the circuit breaker; and $\eta$ is a total contact wear rate.

FIG. 1

20

FIG. 2a

FIG. 2b

EEPROM

FLASH

FIG. 3

FIG. 4

FIG. 5

FIG. 6

FIG. 7a

FIG. 7b

FIG. 8a

FIG. 8b

FIG. 8c

FIG. 9

VCC

R68  R69

VCC

HDC2010

R60

C56

VDD    SCL      SCL
ADDR   SDA      SDA
GND DRDY_INT    INT

GND

HDC2010

R61

GND

GND

FIG. 10a

VCC

GND  R7      R8

VIN
GND    SCL
SCL
SDA    SDA

BMP180

FIG. 10b

FIG. 10c

FIG. 11

FIG. 12

## INTERNATIONAL SEARCH REPORT

| | International application No. |
|---|---|
| | **PCT/CN2023/100340** |

**A. CLASSIFICATION OF SUBJECT MATTER**

H01H71/04(2006.01)i; G01R31/327(2006.01)i

According to International Patent Classification (IPC) or to both national classification and IPC

**B. FIELDS SEARCHED**

Minimum documentation searched (classification system followed by classification symbols)

IPC:H01H, G01R

Documentation searched other than minimum documentation to the extent that such documents are included in the fields searched

Electronic data base consulted during the international search (name of data base and, where practicable, search terms used)

CNPAT, CNKI, VEN, IEEE: 全面感知, 断路器, 控制器, 自检, 电流采样, 互感器, 断线, 磁通, 辅助电源, 储能, 操作机构, 脱扣, 检测, comprehensive, breaker, controller, MCU, self, sampling, inductor, auxiliary, power, operation, tripping, detecting

**C. DOCUMENTS CONSIDERED TO BE RELEVANT**

| Category* | Citation of document, with indication, where appropriate, of the relevant passages | Relevant to claim No. |
|---|---|---|
| PX | CN 218385063 U (ZHEJIANG CHINT ELECTRICS CO., LTD.) 24 January 2023 (2023-01-24) description, paragraphs [0057]-[0118], and figures 1-12 | 1-15 |
| Y | CN 103777137 A (SHANGHAI NOARK ELECTRIC CO., LTD.) 07 May 2014 (2014-05-07) description, paragraphs [0005]-[0036], and figures 1-6 | 1-15 |
| Y | CN 214479833 U (ZHEJIANG CHINT ELECTRICS CO., LTD.) 22 October 2021 (2021-10-22) description, paragraphs [0031]-[0059], and figures 1-4 | 1-15 |
| Y | CN 105242167 A (CHINA SOUTHERN POWER GRID CO., LTD. et al.) 13 January 2016 (2016-01-13) description, paragraphs [0023]-[0035], and figures 1-2 | 4 |
| A | CN 215219114 U (SHANGHAI LIANGXIN ELECTRICAL CO., LTD.) 17 December 2021 (2021-12-17) entire document | 1-15 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **08 August 2023** | **17 August 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/100340**

**C.     DOCUMENTS CONSIDERED TO BE RELEVANT**

| Category* | Citation of document, with indication, where appropriate, of the relevant passages | Relevant to claim No. |
|---|---|---|
| A | CN 216285597 U (SHANGHAI CHINT INTELLIGENT TECHNOLOGY CO., LTD.) 12 April 2022 (2022-04-12)<br>entire document | 1-15 |
| A | WO 2021160179 A1 (ZHEJIANG CHINT ELECTRICS CO., LTD.) 19 August 2021 (2021-08-19)<br>entire document | 1-15 |

Form PCT/ISA/210 (second sheet) (July 2022)

<table>
<tr><td colspan="4" align="center"><strong>INTERNATIONAL SEARCH REPORT</strong><br>Information on patent family members</td><td colspan="2">International application No.<br><br><strong>PCT/CN2023/100340</strong></td></tr>
<tr><td colspan="2" align="center">Patent document<br>cited in search report</td><td align="center">Publication date<br>(day/month/year)</td><td colspan="2" align="center">Patent family member(s)</td><td align="center">Publication date<br>(day/month/year)</td></tr>
<tr><td>CN</td><td>218385063 U</td><td>24 January 2023</td><td colspan="2" align="center">None</td><td></td></tr>
<tr><td>CN</td><td>103777137 A</td><td>07 May 2014</td><td colspan="2" align="center">None</td><td></td></tr>
<tr><td>CN</td><td>214479833 U</td><td>22 October 2021</td><td colspan="2" align="center">None</td><td></td></tr>
<tr><td>CN</td><td>105242167 A</td><td>13 January 2016</td><td colspan="2" align="center">None</td><td></td></tr>
<tr><td>CN</td><td>215219114 U</td><td>17 December 2021</td><td>CN</td><td>115113097 A</td><td>27 September 2022</td></tr>
<tr><td>CN</td><td>216285597 U</td><td>12 April 2022</td><td colspan="2" align="center">None</td><td></td></tr>
<tr><td>WO</td><td>2021160179 A1</td><td>19 August 2021</td><td>EP</td><td>4105961 A1</td><td>21 December 2022</td></tr>
<tr><td></td><td></td><td></td><td>KR</td><td>20220146510 A</td><td>01 November 2022</td></tr>
<tr><td></td><td></td><td></td><td>CN</td><td>211654725 U</td><td>09 October 2020</td></tr>
<tr><td></td><td></td><td></td><td>CN</td><td>211628996 U</td><td>02 October 2020</td></tr>
<tr><td></td><td></td><td></td><td>CN</td><td>113257631 A</td><td>13 August 2021</td></tr>
<tr><td></td><td></td><td></td><td>CN</td><td>113257633 A</td><td>13 August 2021</td></tr>
<tr><td></td><td></td><td></td><td>IN</td><td>202227051470 A</td><td>16 December 2022</td></tr>
</table>

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 211579947 U

- CN 201922215425